# EUROPÄISCHE PATENTSCHRIFT

(11) **EP 0 356 678 B1**
(45) Veröffentlichungstag und Bekanntmachung des Hinweises auf die Patenterteilung: **07.09.1994**
(21) Anmeldenummer: 89113006.4
(22) Anmeldetag: 15.07.1989
(51) Int. Cl.: C04B 37/02

(54) **Verfahren zur Herstellung einer Lotbeschichtung auf metallisierte Keramik**
Process for producing a solder coating on a metallized ceramic article
Procédé de fabrication d'une couche de soudure sur une céramique métallisée

(30) Priorität: 22.07.1988 DE 3824900
(43) Veröffentlichungstag der Anmeldung: 07.03.1990
(73) Patentinhaber: Hoechst CeramTec Aktiengesellschaft, 95100 Selb (DE)
(72) Erfinder: Do-Thoi, Tha, D-8505 Röthenbach (DE); Popp, Klaus, D-8500 Nürnberg 20 (DE)
(74) Vertreter: Isenbruck, Günter, Dr.

(56) Entgegenhaltungen:
- US-A- 2 836 885
- US-A- 4 342 632
- US-A- 4 610 934
- US-A- 4 746 054
- MODERN ELECTRONIK, Nr. 13, August 1988, Seiten 62-63, SE; G. CHRISTIERNIN:"MLC-tillverkningen i närbild"

## Beschreibung

Die vorliegende Erfindung betrifft ein Verfahren zum Aufbringen eines Lots, insbesondere eines Hartlots, auf eine metallisierte Keramik unter Verwendung chemischer oder galvanischer Abscheidungsprozesse
Die Aufgabe eine gasdichte und haftfeste Verbindung zwischen Metallteilen (insbesondere Metallelektroden aus Kupfer, Niob oder Stahl) und isolierenden Keramikteilen (insbesondere Aluminiumoxid) zu schaffen, tritt insbesondere bei der Herstellung von elektronischen Bauteilen (z.B. Überspannungsableiter, Gehäuse für Thyristoren, Vakuumschaltrohre) auf. Üblicherweise wird diese Aufgabe durch ein mehrstufiges Verfahren gelöst. Im ersten Schritt werden die mit dem Metall zu verbindenden Keramikoberflächen zunächst nach dem klassischen Molybdän/Mangan- oder Wolfram-Titan-Metallisierungsverfahren metallisiert. Die entstehende dünne Metallschicht (2 - 30 µm) wird in feuchter, reduzierender Atmosphäre bei Temperaturen von 1200°C bis 1500°C eingebrannt. Auf diese Weise läßt sich eine gute Haftung zwischen Keramikgrundwerkstoff und Metallisierung erreichen. Anschließend wird üblicherweise auf die Metallisierungsschicht ein Nickel- oder Kupferüberzug galvanisch oder chemisch aufgetragen. Der Überzug aus Nickel oder Kupfer ist etwa 0,5 bis 5 µm dick und hat lediglich die Aufgabe, die Benetzung der metallisierten Keramik durch das geschmolzene Lot zu ermöglichen. Im nächsten Arbeitsgang werden die zu lötenden Bauteile in einer Lötlehre aus Graphit montiert. Auf die metallisierte Keramikoberfläche wird eine Lotscheibe (z.B. auf Silber/Kupfer-Basis, gelegt. Das mit der Keramik zu verbindende Metallteil wird auf die Lotscheibe aufgesetzt und mit Hilfe der Lötlehre exakt zentriert. Lötlehre einschließlich Keramik, Metallteil und Lotscheibe werden in Schutzgas oder Vakuum auf Temperaturen zwischen 750°C und 1200°C aufgeheizt. Bei der Löttemperatur werden Metall- und Keramikoberfläche von dem geschmolzenem Lot benetzt. Das nach der Abkühlung erstarrte Lot bewirkt eine haftfeste und gasdichte Verbindung zwischen den Metall- und Keramikteilen. Als Hartlot werden in der Elektronik häufig Silber/Kupfer-Legierungen eingesetzt. In Abhängigkeit von dem Gewichtsanteil von Kupfer läßt sich der Schmelzpunkt dieses Lotes im Bereich von 780 (Eutektikum) bis etwa 1070°C (reines Kupfer) variieren.
Die chemischen und physikalischen Eigenschaften (Wärmeausdehnung) des Hartlotmaterials müssen auf die Metallisierung der Keramik und die Eigenschaften des Metallteiles abgestimmt sein. Der Schmelzpunkt des Lots (Einstoff-System oder Eutektikum) bzw. sein Schmelzbereich (Mehrstoffsystem) muß im Bereich der zulässigen Verarbeitungstemperatur liegen.

Ein solches Verfahren wird beispielsweise in der US-A-4610934 beschrieben. Nachteilig an dem seit Jahren bekannten Verfahren ist aber, daß das Einpassen der Lotteile (z.B. Lotscheiben) bei der Montage besonders arbeitsintensiv ist und manuelles Geschick erfordert. Eine Automatisierung der Montage ist nicht möglich. Dies gilt insbesondere bei geometrisch komplizierten Lötstellen oder bei Gegenständen mit mehreren Lötstellen. Das Problem wird noch dadurch verschärft, daß in der Elektronik häufig kleine Bauteile aus metallisierter Keramik in hohen Stückzahlen benötigt werden.

Es wurde nun überraschend ein Verfahren gefunden, das den Nachteil des manuellen Einpassens von Lotteilen vermeidet. Das Verfahren der eingangs genannten Gattung zeichnet sich durch das Kennzeichenmerkmal aus, daß man auf die mit Molybdän, Molybdän/Mangan, Wolfram oder Wolfram/Titanoxid metallisierte Keramik aus Aluminiumoxid oder Steatit chemisch oder galvanisch mindestens zwei Schichten jeweils bestehend aus Nickel, Kupfer, Silber, Zink oder Zinn aufträgt. Die erhaltene Beschichtung weist vorzugsweise eine Gesamtdicke von 15 bis 300 µm, insbesondere 15 bis 150 µm, auf. Dabei werden die einzelnen Elemente nacheinander abgeschieden. Je länger die Expositionszeit, bzw. je höher die Stromdichte und die Konzentration des Bades ist, desto größer wird die Schicht des abgeschiedenen Elements. Beim Löten kommt es dann je nach den gewählten Bedingungen (Temperatur, Dauer) zur Bildung einer flüssigen Phase zu einer mehr oder minder starken Vermischung der Schichten und Bildung einer mehr oder weniger homogenen Legierung. Gesamtschichtdicken über 150 µm sind möglich aber weniger vorteilhaft als geringere Dicken (Kosten für Material und Arbeitsaufwand) mit mindestens gleicher Haftfestigkeit.

Vorzugsweise bringt man auf die metallisierte Keramik mindestens je eine Schicht aus Zinn, Zink, Kupfer und Silber auf, wobei der Zinn-Anteil maximal 10 Gew.-% (bezogen auf die insgesamt aufgetragene Schicht) beträgt. Die Reihenfolge des Aufbringens ist nicht kritisch.

Legierungen mit 30 bis 55 Gew.-% Silber, 22 bis 36 Gew.-% Kupfer, 18 bis 32 Gew.-% Zink und 2 bis 5 Gew.-% Zinn werden verwendet, um Stahl, Kupfer oder Nickel zu löten (vgl. Merkblatt DODUCO, "Typen-Übersicht Hartlote·Weichlote·Flußmittel", Abschnitt "Cadmiumfreie Lote", Lotnummern 8855, 8845, 8838, 8834 und 8830).

Nach einer weiteren Ausgestaltung der Erfindung läßt man Zinn weg. Danach besteht die aufgetragene Beschichtung aus mindestens je einer Schicht Kupfer, Silber und Zink. Legierungen aus diesen Elementen werden üblicherweise verwendet um Silber, Silberlegierungen, Stahl, Kupfer, Nickel und Nickellegierungen zu verlöten (vgl. Merkblatt DODUCO, Abschnitt "Cadmiumfreie Lote", z.B. Lotnummern 8075 bis 8830).

Nach einer bevorzugten Ausgestaltung der Erfindung trägt man zunächst auf die metallisierte Keramik eine Schicht aus Nickel, Kupfer oder Silber in einer Dicke von mindestens 0,5 µm und dann mindestens eine weitere Schicht aus Nickel, Kupfer oder Silber in einer Schichtdicke von 10 bis 150 µm auf, so daß eine Gesamtschicht der Dicke 15 bis 300 µm entsteht. Vorzugsweise beträgt die Gesamtdicke der aufgetragenen Schichten maximal 150 µm insbesondere 30 bis 100 µm. Die Einzelschichten aus Kupfer und Silber weisen vorteilhafterweise Dicken von 5 bis 60, insbesondere 6 bis 50 µm auf. Beispielsweise kann man zunächst eine 0,5 bis 5 µm dicke Schicht aus Kupfer oder Nickel und hierauf drei dickere Schichten aus Silber, aus Nickel und aus Kupfer auftragen, die zusammen 15 bis 150 µm dick sind.

Dabei sind mehrere Varianten denkbar, je nachem welches Metall die zuerst aufgetragene Schicht bildet. Wenn dieses Metall Nickel ist, so soll seine Schichtdicke 0,5 bis maximal 5 µm ausmachen. Darauf wird mindestens eine weitere Schicht aus Kupfer oder Silber in einer Schichtdicke von 1 bis 150 µm, insbesondere 1 bis 70 µm aufgetragen, wobei die aufgetragenen Schichten eine Gesamtdicke von 16 bis 160 µm aufweisen. Nickel dient hier im wesentlichen zur Verbesserung der Haftung der folgenden Schichten auf der metallisierten Keramik.
Es ist bereits bekannt, metallisierte Keramik mit dünnen Schichten aus Nickel oder Kupfer zu versehen, damit später das Lötmetall besser an der metallisierten Keramik haftet. Gemäß US-A-2 667 427 wird zunächst Nickel und dann Kupfer abgeschieden, falls ein Silber-Lot benutzt wird. Die abgeschiedenen Mengen können das Lot jedoch nicht ersetzen.

Man kann auch zunächst eine dünne Schicht aus Kupfer (0,5 bis maximal 5 µm) auftragen und dann mindestens eine weitere Schicht bestehend aus Kupfer oder Silber, wobei jede einzelne Schicht 15 bis 150 µm dick ist und die aufgetragenen Schichten eine Gesamtdicke von 16 bis 160 µm aufweisen. Die zunächst auf getragene dünne Kupferschicht dient ebenfalls der Verbesserung der Haftung der folgenden Schichten auf der metallisierten Keramik.

Unabhängig davon, ob die erste dünne Schicht aus Nickel oder Kupfer besteht, kommt es unter den Lötbedingungen zumindest örtlich zur Bildung einer homogenen Kupfer/Silber-Legierung. Die Eigenschaften solcher Legierungen in Abhängigkeit vom Cu/Ag-Verhältnis sind bekannt.

Man kann aber auch die zunächst aufgetragene Schicht aus Kupfer dicker herstellen (Schichtdicke 5 bis 70 µm, insbesondere 10 bis 70 µm) oder eine gleich dicke erste Schicht aus Silber erzeugen und dann in beiden Fällen mindestens eine weitere Schicht aus Kupfer oder Silber (Einzelschichtdicke 1 bis 70 µm) auftragen, wobei eine Gesamtschichtdicke von 15 bis 300 µm angestrebt wird. Besser ist eine maximale Gesamtdicke von 200, noch besser 140, insbesondere maximal 100 µm. Wird als Lot reines Kupfer gewünscht, so ist Vorverkupferung und Nachverkupferung in einem Arbeitsgang aufzubringen. Analoges gilt für eine ausschließliche Beschichtung mit Ag.

Durch Einbau geringer Anteile an Nickel läßt sich der Schmelzpunkt des aufgetragenen Schichtsystems erhöhen. Falls die Beschichtung aus mindestens je einer Schicht Silber, Kupfer und Nickel besteht (und die Beschichtung maximal 10 Gew.-% Nickel enthält) läßt sich erreichen, daß der Schmelzpunkt des beim Löten entstehenden Dreistoff-Systems maximal 1100°C beträgt. Das Lot 67 Ag 28 Cu 5 Ni hat eine Arbeitstemperatur von 850°C.

Unabhängig von der zuerst aufgetragenen Schicht (Ag, Cu, Ni) kann das Gewichtsverhältnis Ag/Cu der insgesamt aufgetragenen Schichten 0:100 - 100:0 betragen. Bevorzugt werden jedoch sowohl Silber wie Kupfer verwendet, bei Gewichtsverhältnissen Ag/Cu von 5:100 bis 90:10, insbesondere 85:15 bis 50:50. Besonders bevorzugt wegen der niedrigen Schmelzpunkte sind Verhältnisse in der Nähe des Eutektikums (Ag/Cu = 72:28) von 75:25 bis 70:30.

Wenn zur Beschichtung lediglich die Metalle Silber und Kupfer aufgetragen werden, ist es vorteilhaft, wenn die zuerst aufgetragene Schicht aus Kupfer und die zuletzt aufgetragene Schicht, die die äußere Oberfläche bildet, aus Silber besteht. In diesem Fall wird die gute Haftfestigkeit des Kupfers verknüpft mit der guten Oxidationsbeständigkeit des Silbers. Der optimale Schichtdickenbereich für das Lot Ag/Cu liegt in diesem Fall im Bereich von 30 bis 100 µm. Bei größeren Dicken nimmt die Haftfestigkeit etwas ab.

Bei Einhaltung dieser Gewichtsverhältnisse lassen sich Beschichtungen erzielen, die beim Erhitzen Lote mit einem Schmelzpunkt unter 1000°C bilden.

Die Metallisierung von Aluminiumoxid-Keramik ist bekannt, (vgl. z.B.
1. Cole, S.S. and G. Sommer, Glass-Migration Mechanisms of Ceramic-to-Metal Seal Adherence, J.Am.Ceram.Soc, Vol. 44 No. 6, p. 265-271
2. Fulrath, R.M. and E.L. Hollar, Manganese Glass-Molybdenum Metallizing Ceramics, Ceramic Bulletin, Vol. 47, No. 5 (1968), p. 493-497
3. Klomp. J.T. and Th.P.J. Botden, Sealing Pure Aluminia Ceramics to Metals, Ceramic Bulletin, Vol. 49, No. 2 (1970), p. 204-211
4. Cowan, R.E. and S.D. Stoddard, Tungsten Metallizing Aluminia-Yttria Ceramics, Report LA-6705-MS, Los Alamos, New Mexico (1977)
5. Meyer, A., Zum Haftmechanismus von Molybdän/Mangan-Metallisierungsschichten auf Korundkeramik, Ber.DKG, Bd 42 (1965), Heft 11, p. 405-444 ).

Erfindungsgemäß besteht die Metallisierung aus Molybdän, Wolfram, Wolfram/Titandioxid oder Molybdän/Mangan. Sinnvollerweise bestehen jeweils nacheinander aufgetragene Schichten des Lotmetalls aus unterschiedlichen Metallen. Wenn man nacheinander zwei gleiche Metalle aufträgt, läßt sich später im allgemeinen nur eine einzige Schicht erkennen.

Verfahren zur Abscheidung der reinen Metalle Ni, Cu, Ag, Zn, Sn in Schichtform auf galvanischem oder stromlosem Weg auf leitfähige Grundmaterialien sind dem Fachmann bekannt. Bäder, die diese Abscheidung stromlos oder insbesondere galvanisch erlauben, sind im Handel verfügbar. Auch die Reinigung der Grundmaterialien und ihre Aktivierung (im Fall der stromlosen Abscheidung von Metallen) sind dem Galvano-Fachmann bekannt.

In der Praxis ist es leichter, das Fortschreiten der Abscheidung durch Messung der Zunahme der Dicke der aufgetragenen Schichten als durch Wiegen zu verfolgen. Aus den bekannten Zustandsdiagrammen für ein angestrebtes Mehrstoff-System und der Dichte der Metalle läßt sich das Verhältnis der Schichtdicken der Metalle jedoch leicht errechnen.

Bei der galvanischen Abscheidung mehrerer Schichten unterschiedlicher Materialien zum Zweck einer Hartlot - Legierungsbildung, ist die Reihenfolge der Abscheidungen für die eigentliche Legierungsbildung unwesentlich. Vorzugsweise werden die Schichtfolgen jedoch so gewählt, daß eine galvanotechnisch - sinn volle Verfahrenstechnik angewendet werden kann oder die korrosionsbeständigste Schicht als letzte abgeschieden wird.

Nach dem erfindungsgemäßen Verfahren läßt sich ein Keramikkörper gewinnen, auf dem von innen nach außen nacheinander
a) eine dünne Metallisierungsschicht aus Wolfram oder Wolfram/Titandioxid, Molybdän oder Molybdän/Mangan,
b) eine Schicht aus Nickel in einer Schichtdicke von 0,5 bis 5 µm oder Kupfer oder Silber in einer Schichtdicke von 1 bis 70 µm und dann
c) mindestens eine weitere Schicht aus Kupfer oder Silber in einer Schichtdicke von 1 bis 70 µm festhaftend angeordnet sind, wobei die auf der Metallisierung angeordneten Schichten eine Gesamtschichtdicke von 15 bis 150 µm aufweisen.

In der Elektrotechnik spielen häufig solche Keramikkörper eine Rolle, die die Form eines Hohlzylinders aufweisen und bei denen mindestens eine ringförmige Stirnseite oder aber mindestens eine manschettenförmige Mantelzone nahe der Ringfläche für ein späteres Verlöten metallisiert sind. Besonders häufig werden Hohlzylinder benötigt, deren Außendurchmesser maximal 20 mm, insbesondere maximal 12 mm und deren Länge maximal 20 mm beträgt. Der Innendurchmesser beträgt mindestens 3,5 mm, die Wandstärke mindestens 0,8 mm. Nach dem erfindungsgemäßen Verfahren kann auch in diesen Fällen die Metallisierung leicht durch Lotschichten bedeckt werden.

Die Erfindung betrifft ferner ein Verfahren zum Verlöten einer metallisierten Keramik mit einem Metallgegenstand, wobei man zwischen metallisierter Keramik und Metallgegenstand ein Hartlot anordnet, dessen Schmelzpunkt niedriger liegt als der des Metallgegenstands, man das System aus metallisierter Keramik, Hartlot und Metallgegenstand auf eine Temperatur erhitzt, die oberhalb des Schmelzpunktes des Hartlots aber unterhalb des Schmelzpunkts des Metallgegenstands liegt und man das System aus geschmolzenem Lot, metallisierter Keramik und Metallgegenstand unter den Schmelzpunkt des Lote abkühlt. Dabei bringt man das Hartlot zunächst in der beschriebenen Weise auf der Keramik aus Aluminiumoxid oder Steatit auf und erhitzt den mit Hartlot beschichteten Teil der Oberfläche der Keramik im Kontakt mit dem Metallgegenstand.

Verwendbar sind z.B. Metallteile aus Eisen und Eisenlegierungen, wie z.B. Eisen-Nickel-Werkstoffen, insbesondere Vacodil (Werkstoff Nr. 1.3917), Eisen-Nickel-Kobalt-Werkstoffen, insbesondere Vacon (Werkstoff Nr. 1.3981, 1.3982) oder Kupfer, Kupferlegierungen, wie z.B. Zirkonkupfer, Wolfram, Molybdän, Niob und Tantal. Alle diese Metalle werden durch Lote aus AgCu bzw. AgCuNi gut benetzt.

Für die Haftfestigkeit der Metall-Keramik-Verbindung ist es von Vorteil, wenn Lot, Keramik- und Metallpartner einen ähnlichen Ausdehnungskoeffizienten aufweisen. In ihrer Beständigkeit gegenüber mechanischen Belastungen sind Schneidelötungen den Stumpflötungen überlegen.

Die Erfindung wild durch die Beispiele näher erläutert.

### Beispiel 1

Teile aus Aluminiumoxid-Keramik die partiell metallisiert wurden, werden galvanisch vernickelt. Dabei wird auf die Metallisierung eine Nickelschicht von etwa 3 µm aufgetragen. Nach einer zwischenspülung werden galvanotechnisch 40 µm Silber abgeschieden. Zum Verlöten mit einem Kupferblech wird die Keramik in einer Lötlehre aus Graphit in Kontakt mit dem Kupferteil gebracht und auf 961°C erhitzt. Im Bereich des Kupferbleches bildet sich ein Eutektikum mit einem Schmelzpunkt von etwa 780°C. Das Kupferblech ist festhaftend mit der Keramik verbunden.

### Beispiel 2

Aluminiumoxid-Keramik, die metallisiert wurde, wird chemisch mit einer Kupferschicht von 4 µm überzogen. Anschließend werden galvanotechnisch ca. 16 µm Kupfer und ca. 34 µm Silber abgeschieden.
Man bringt die beschichtete Keramik in Kontakt mit einem Metallteil aus Vacon und heizt unter Schutzgas auf eine Löttemperatur von 800°C auf. Dabei wird zunächst an der Schichtgrenze Cu/Ag das Eutektikum Cu/Ag gebildet, das noch überschüssiges Ag aufnimmt. Nach dem Abkühlen ist die Keramik mit dem Metallteil haftfest und vakuumdicht verlötet.

### Beispiel 3

Mehrere Al₂O₃-Hohlzylinder (Durchmesser innen 6 mm, außen 7,5 mm) werden mit Mo/Mn metallisiert und mit Kupfer (12 µm) beschichtet. Dann wird galvanisch eine Silberschicht einer Dicke von 9 bis 17 µm aufgetragen. Schließlich wird jeweils auf eine Stirnfläche des Hohlzylinders eine kegelförmige Kappe aus Vacon durch Erhitzen auf 830°C aufgelötet. Die verlöteten Hohlzylinder sind vakuumdicht. Die Haftfestigkeit der Kappe auf der Keramik weist in Abhängigkeit von der Dicke der Silberschicht ein Maximum von etwa 900 N auf. Bei 9 und 15 µm Ag beträgt die Haftfestigkeit ca. 825 N, bei 11 und 13 µm Ag ca. 880 N und bei 17 µm Ag nur ca. 700 N.

Arbeitet man dagegen nach einem konventionellen Verfahren (3 µm Vernickelung; Lotscheibe aus Ag/Cu der Zusammensetzung 72/28) so beträgt die Haftfestigkeit unabhängig von der Dicke der Lotschicht ca. 800 N.

## Patentansprüche

1. Verfahren zum Aufbringen eines Lotes auf eine metallisierte Keramik, dadurch gekennzeichnet, daß man auf die mit Molybdän, Molybdän/Mangan, Wolfram oder Wolfram/Titanoxid metallisierte Keramik aus Aluminiumoxid oder Steatit chemisch oder galvanisch mindestens zwei Schichten jeweils bestehend aus Nickel, Kupfer, Silber, Zink oder Zinn aufträgt.

2. Verfahren nach Anspruch 1, dadurch gekennzeichnet, daß man mindestens je eine Schicht aus Kupfer, Silber, Zink und Zinn aufbringt, wobei der Gewichtsanteil an Zinn maximal 10 Gew.-% beträgt.

3. Verfahren nach Anspruch 1, dadurch gekennzeichnet, daß man auf die metallisierte Keramik mindestens je eine Schicht aus Kupfer, Silber und Zink aufbringt.

4. Verfahren nach Anspruch 1, dadurch gekennzeichnet, daß man auf die metallisierte Keramik zunächst eine Schicht aus Nickel, Kupfer oder Silber in einer Dicke von mindestens 0,5 µm und dann mindestens eine weitere Schicht aus Nickel, Kupfer oder Silber mit einer Schichtdicke von 10 bis 150 µm aufbringt, so daß eine Gesamtschichtdicke von 15 bis 300 µm erhalten wird.

5. Verfahren nach Anspruch 1, dadurch gekennzeichnet, daß man auf die metallisierte Keramik zunächst eine Schicht aus Kupfer in einer Dicke von 0,5 bis maximal 5 µm und dann mindestens eine weitere Schicht bestehend aus Kupfer oder Silber in einer Schichtdicke von 1 bis 150 µm, insbesondere 1 bis 70 µm, aufbringt, so daß eine Gesamtdicke von 16 bis 155 µm erhalten wird.

6. Verfahren nach Anspruch 4, dadurch gekennzeichnet, daß man auf die metallisierte Keramik zunächst eine Schicht aus Kupfer in einer Dicke von 0,5 bis maximal 5 µm aufbringt und dann mindestens eine weitere Schicht bestehend aus Kupfer oder Silber mit einer Schichtdicke von 15 bis 150 µm aufbringt, so daß eine Gesamtdicke von 16 bis 155 µm erhalten wird.

7. Verfahren nach Anspruch 1, dadurch gekennzeichnet, daß man auf die metallisierte Keramik zunächst eine erste Schicht aus Kupfer oder Silber mit einer Schichtdicke von über 5 µm und maximal 70 µm aufbringt und dann mindestens eine weitere Schicht bestehend aus Kupfer oder Silber mit einer Schichtdicke von 1 bis 70 µm aufbringt, so daß eine Gesamtdicke von 15 bis 140 µm erhalten wird.

8. Verfahren nach Anspruch 4, dadurch gekennzeichnet, daß man mindestens je eine Schicht aus Kupfer, Silber und Nickel aufbringt und das Verhältnis der Schichtdicken so wählt, daß der Schmelzpunkt des Dreistoffsystems maximal 1100 °C beträgt.

9. Verfahren nach Anspruch 4, dadurch gekennzeichnet, daß die aufgetragenen Schichten eine Gesamtdicke von 15 bis 130 µm, insbesondere 30 bis 100 µm, aufweisen.

10. Verfahren nach Anspruch 4, dadurch gekennzeichnet, daß die weiter aufgetragenen Schichten aus Kupfer oder Silber bestehen und jeweils eine Dicke von 5 bis 60 µm, insbesondere von 6 bis 50 µm, aufweisen.

11. Verfahren nach einem der Ansprüche 1 bis 10, dadurch gekennzeichnet, daß jeweils nacheinander aufgetragene Schichten aus unterschiedlichen Elementen bestehen.

12. Verfahren nach Anspruch 6 oder 7, dadurch gekennzeichnet, daß die insgesamt aufgetragenen Gewichtsteile von Silber und Kupfer sich wie 0 : 100 bis 100 : 0, insbesondere 5 : 100 bis 90 : 10, verhalten.

13. Verfahren nach Anspruch 12, dadurch gekennzeichent, daß die insgesamt aufgetragenen Gewichtsteile von Silber und Kupfer sich wie 85 : 15 bis 50 : 50, vorzugsweise wie 75 : 25 bis 70 : 30, verhalten.

14. Verfahren nach Anspruch 13, dadurch gekennzeichent, daß die insgesamt aufgetragenen Gewichtsteile von Silber und Kupfer sich wie 72 : 28 verhalten.

15. Verfahren nach Anspruch 12, dadurch gekennzeichnet, daß zwei Schichten aufgetragen werden, wobei die erste aus Kupfer und die zweite aus Silber besteht.

16. Metallisierte Keramik mit aufgebrachter Hartlotschicht bestehend aus einem Keramikkörper aus Aluminiumoxid oder Steatit, auf dem nacheinander
a) eine dünne Metallisierungsschicht aus Titan, Molybdän oder Wolfram,
b) eine Schicht aus Nickel in einer Schichtdicke von 0,5 bis 5 µm oder Kupfer oder Silber in einer Schichtdicke von 1 bis 70 µm und
c) mindestens eine weitere Schicht aus Kupfer oder Silber in einer Schichtdicke von 1 bis 70 µm
festhaftend angeordnet sind, wobei jeweils nebeneinanderliegende Schichten aus unterschiedlichen Metallen bestehen, die auf der Metallisierung angeordneten Schichten eine Gesamtschichtdicke von 15 bis 150 µm aufweisen und die insgesamt vorhandene Mengen von Silber / Kupfer sich wie 5 : 100 bis 100 : 0 verhalten.

17. Metallisierte Keramik nach Anspruch 16, dadurch gekennzeichnet, daß die Metallschichten Ringflächen bilden, die auf mindestens einer Stirnseite eines hohlzylinderförmigen Keramikkörpers angeordnet sind.

18. Metallisierte Keramik nach Anspruch 16, dadurch gekennzeichnet, daß die Metallschicht umfassend Metallisierungsschicht und Lotschicht manschettenförmig an mindestens einem Ende eines hohlzylinderförmigen Keramikkörpers angeordnet ist.

19. Metallisierte Keramik nach Anspruch 17 oder 18, dadurch gekennzeichnet, daß der Durchmesser des hohlzylinderförmigen Keramikkörpers maximal 20 mm und seine Länge maximal 20 mm beträgt.

20. Verfahren zum Verlöten einer metallisierten Keramik mit einem Metallgegenstand, bei dem man zwischen der metallisierten Keramik und dem Metallgegenstand ein Hartlot anordnet, dessen Schmelzpunkt niedriger liegt als der Schmelzpunkt des Metallgegenstandes, man das System aus metallisierter Keramik, Hartlot und Metallgegenstand auf eine Temperatur erhitzt, die oberhalb des Schmelzpunktes des Hartlots, aber unterhalb des Schmelzpunktes des Metallgegenstandes liegt, und man das System aus geschmolzenem Lot, metallisierter Keramik und Metallgegenstand unter den Schmelzpunkt des Lots abkühlt, dadurch gekennzeichnet, daß man das Hartlot nach einem Verfahren nach einem der Ansprüche 1 bis 15 auf die metallisierte Keramik aus Aluminiumoxid oder Steatit aufbringt und daß man den mit Hartlot beschichteten Teil der Oberfläche der Keramik erhitzt und mit dem Metallgegenstand in Kontakt bringt.

## Claims

1. A process for applying a solder to a metallized ceramic part, wherein at least two layers comprising in each case nickel, copper, silver, zinc or tin, are applied galvanically or chemically to the ceramic part comprising aluminium oxide or steatite and metallized with molybdenum, molybdenum/manganese, tungsten or tungsten/titanium oxide.

2. The process as claimed in claim 1, wherein at least one layer each of copper, silver, zinc or tin is applied, the proportion by weight of tin being not more than 10 % by weight.

3. The process as claimed in claim 1, wherein at least one layer each of copper, silver and zinc is applied to the metallized ceramic part.

4. The process as claimed in claim 1, wherein a layer of nickel, copper or silver is first applied to the metallized ceramic part in a thickness of at least 0.5 µm, followed by at least one further layer of nickel, copper or silver with a layer thickness of 10 to 150 µm, so that a total layer thickness of 15 to 300 µm is obtained.

5. The process as claimed in claim 1, wherein a layer of copper is first applied to the metallized ceramic part in a thickness of 0.5 to not more than 5 µm, followed by at least one further layer of copper or silver in a layer thickness of 1-150 µm, especially 1-70 µm, so that a total thickness of 16 to 155 µm is obtained.

6. The process as claimed in claim 4, wherein a layer of copper or silver is first applied to the metallized ceramic part in a layer thickness of 0.5 to not more than 5 µm, followed by at least one further layer of copper or silver with a layer thickness of 15 to 150 µm, so that a total thickness of 16 to 155 µm is obtained.

7. The process as claimed in claim 1, wherein a first layer of copper or silver is first applied to the metallized ceramic part with a layer thickness of more than 5 µm and not more than 70 µm, followed by at least one further layer of copper or silver with a layer thickness of 1 to 70 µm, so that a total thickness of 15 to 140 µm is obtained.

8. The process as claimed in claim 1, wherein at least one layer each of copper, silver and nickel is applied and the ratio of the layer thicknesses is chosen such that the melting point of the three-component system is not more than 1100°C.

9. The process as claimed in claim 4, wherein the applied layers have a total thickness of 15 to 130 µm, especially 30 to 100 µm.

10. The process as claimed in claim 4, wherein the further applied layers are of copper or silver and each have a thickness of 5 to 60 µm, especially 6 to 50 µm.

11. The process as claimed in one of claims 1 to 10, wherein the layers applied successively in each case are composed of different elements.

12. The process as claimed in claim 6 or 7, wherein the total of the applied proportions by weight of silver and copper are in the ratio 0:100 to 100:0, in particular 5:100 (sic) to 90:10.

13. The process as claimed in claim 12, wherein the total of the applied proportions by weight of silver and copper are in the ratio 85:15 to 50:50, preferably 75:25 to 70:30.

14. The process as claimed in claim 13, wherein the total of the applied proportions by weight of silver and copper are in the ratio 72:28.

15. The process as claimed in claim 12, wherein two layers are applied, the first layer being of copper and the second of silver.

16. A metallized ceramic part with applied hard solder layer composed of a ceramic body of aluminium oxide or steatite on which there are successively located with firm adhesion
a) a thin metallizing layer of titanium, molybdenum or tungsten,
b) a 0.5 to 5 µm thick layer of nickel or a 1 to 70 µm thick layer of copper or silver, and,
c) at least one 1 to 70 µm thick further layer of copper or silver adjacent layers comprising in each case different metals, the layers located on the metallizing layer having a total layer thickness of 15 to 150 µm and the total amounts of silver/copper present are in the ratio 5:100 (sic) to 100:0.

17. The metallized ceramic part as claimed in claim 16, wherein the metal layers form annular areas which are located on at least one front end of a hollow-cylindrical ceramic body.

18. The metallized ceramic part as claimed in claim 16, wherein the metal layer comprising a metallizing layer and solder layer is located in the form of a sleeve on at least one end of a hollow-cylindrical ceramic body.

19. The metallized ceramic part as claimed in claim 17 or 18, wherein the diameter of the hollow cylinder is not more than 20 mm and its length is not more than 20 mm.

20. A process for soldering a metallized ceramic part to a metal object, in which process a hard solder whose melting point is lower than that of the metal object is disposed between the metallized ceramic part and the metal object, the system comprising the metallized ceramic part, the hard solder and the metal object is heated to a temperature which is above the melting point of the hard solder but below the melting point of the metal object, and the system comprising the molten solder, the metallized ceramic part and the metal object is cooled to a temperature below the melting point of the solder, wherein the hard solder is applied to the metallized ceramic part comprising aluminium oxide or steatite by a process as claimed in one of claims 1 to 15, and the part of the ceramic surface coated with the hard solder is heated and brought into contact with the metal object.

## Revendications

1. Procédé pour appliquer une brasure sur une matière céramique métallisée, procédé caractérisé en ce qu'on applique sur une matière céramique en oxyde d'aluminium ou en stéatite, métallisée par du molybdène, du molybdène/manganèse, du tungstène ou du tungstène/oxyde de titane, par voie chimique ou galvanique au moins deux couches consistant à chaque fois en du nickel, du cuivre, de l'argent, du zinc ou de l'étain.

2. Procédé selon la revendication 1, caractérisé en ce qu'on applique au moins une couche en cuivre, argent, zinc et étain, la proportion pondérale de l'étain valant au maximum 10 % en poids.

3. Procédé selon la revendication 1, caractérisé en ce qu'on applique sur la céramique métallisée au moins une couche en cuivre, argent et zinc.

4. Procédé selon la revendication 1, caractérisé en ce qu'on applique sur la céramique métallisée tout d'abord une couche de nickel, de cuivre ou d'argent en une épaisseur d'au moins 0,5 µm, puis au moins une autre couche en nickel, cuivre ou argent ayant une épaisseur de couche de 10 à 150 µm, de façon à obtenir une épaisseur totale de 15 à 300 µm.

5. Procédé selon la revendication 1, caractérisé en ce qu'on applique, sur la céramique métallisée,tout d'abord une couche en cuivre, en une épaisseur de 0,5 à 5 µm au maximum, puis au moins une autre couche consistant en du cuivre ou en de l'argent et ayant une épaisseur de couche de 1 à 150 µm, notamment 1 à 70 µm, de façon à obtenir une épaisseur totale de 16 à 155 µm.

6. Procédé selon la revendication 4, caractérisé en ce qu'on applique sur la céramique métallisée tout d'abord une couche en cuivre, en une épaisseur de 0,55 µm au maximum, puis au moins une autre couche consistant en du cuivre ou en de l'argent, ayant une épaisseur de couche de 15 à 150 µm, de façon à obtenir une épaisseur totale de 16 à 155 µm.

7. Procédé selon la revendication 1, caractérisé en ce qu'on applique sur la céramique métallisée tout d'abord une première couche en cuivre ou en argent ayant une épaisseur de couche, supérieure à 5 µm et de 70 µm au maximum, puis au moins une autre couche consistant en du cuivre ou en de l'argent, ayant une épaisseur de couche de 1 à 70 µm, de façon à obtenir une épaisseur totale de 15 à 140 µm.

8. Procédé selon la revendication 4, caractérisé en ce qu'on applique au moins une couche en cuivre, argent et nickel et en ce que l'on choisit le rapport entre les épaisseurs de couches de façon que le point de fusion du système ternaire ou de trois matières vale au maximum 1100°C.

9. Procédé selon la revendication 4, caractérisé en ce les couches appliquées présentent une épaisseur totale de 15 à 130 µm, notamment 30 à 100 µm.

10. Procédé selon la revendication 4, caractérisé en ce que les autres couches appliquées consistent en du cuivre ou en de l'argent et présentent à chaque fois une épaisseur de 5 à 60 µm, notamment une épaisseur de 6 à 50 µm.

11. Procédé selon l'une des revendications 1 à 10, caractérisé en ce que les couches appliquées successivement consistent chacune en des éléments différents.

12. Procédé selon la revendication 6 ou 7, caractérisé en ce que les parties pondérales d'argent et de cuivre appliquées au total présentent entre elles un rapport correspondant à 0:100 jusqu'à 100:0, notamment 5:100 à 90:10.

13. Procédé selon la revendication 12, caractérisé en ce que les parties pondérales appliquées au total, d'argent et de cuivre, présentent entre elles un rapport de 85:15 à 50:50, avantageusement de 75:25 à 70:30;

14. Procédé selon la revendication 13, caractérisé en ce que les parties pondérales appliquées au total, d'argent et de cuivre, présentent entre elles un rapport de 72:28.

15. Procédé selon la revendication 12, caractérisé en ce qu'on applique deux couches, la première en cuivre et la seconde en argent.

16. Céramique métallisée comportant une couche de brasure dure appliquée consistant en un corps en matière céramique, en oxyde d'aluminium ou en stéatite, sur lequel on applique successivement, de manière à obtenir une bonne adhérence :
a) une mince couche de métallisation en titane, en molybdène ou en tungstène,
b) une couche en nickel, en une épaisseur de couche de 0,5 à 5 µm ou bien en cuivre ou en argent en une épaisseur de couche de 1 à 70 µm, et
c) au moins une autre couche en cuivre ou en argent, en une épaisseur de couche de 1 à 70 µm,
les couches successives consistant à chaque fois en des métaux différents qui, placés en des couches disposées sur la métallisation, représentent une épaisseur totale de couche de 15 à 150 µm et ont au total des quantités présentes d'argent/cuivre selon un rapport de 5:100 à 100:0.

17. Céramique métallisée selon la revendication 16, caractérisée en ce que la couche métallique forme des surfaces annulaires qui sont disposées sur au moins un côté frontal d'un corps en matière céramique en forme de cylindre creux.

18. Céramique métallisée selon la revendication 16, caractérisée en ce que la couche de métallisation comprenant la couche de métal et la couche de brasure en forme de manchette sont disposées sur au moins une extrémité d'un corps en matière céramique en forme de cylindre creux.

19. Céramique métallisée selon la revendication 17 ou 18, caractérisée en ce que le diamètre du corps en céramique en forme de cylindre creux vaut au maximum 20 mm et sa longueur vaut au maximum 20 mm.

20. Procédé pour braser une céramique métallisée avec un objet en métal, selon lequel on dispose une brasure dure ou forte entre la céramique métallisée et l'objet en métal, brasure dont le point de fusion est inférieur au point de fusion de l'objet en métal; on chauffe le système, formé par la céramique métallisée, la brasure forte et l'objet en métal, jusqu'à une température supérieure au point de fusion de la brasure forte, mais inférieure au point de fusion de l'objet en métal et l'on refroidit le système, formé par la brasure fondue, la céramique métallisée et l'objet en métal, jusqu'au dessous du point de fusion de la brasure, procédé caractérisé en ce qu'on applique la brasure dure selon un procédé selon l'une des revendications 1 à 15 sur la céramique métallisée, formée d'oxyde d'aluminium ou de stéatite, et en ce qu'on chauffe la partie, revêtue de brasure dure ou forte, de la surface de la céramique et on la met en contact avec l'objet métallique.
